Europäisches Patentamt

European Patent Office

Office européen des brevets

(19)

(11) Publication number: **0 092 484**
**B1**

(12) **EUROPEAN PATENT SPECIFICATION**

(45) Date of publication of patent specification: **29.10.86**

(51) Int. Cl.⁴: **G 01 P 1/10, G 01 R 13/40**

(21) Application number: **83400770.0**

(22) Date of filing: **19.04.83**

(54) Display unit of tachometer for automobile.

(30) Priority: **20.04.82 JP 64875/82**

(43) Date of publication of application:
**26.10.83 Bulletin 83/43**

(45) Publication of the grant of the patent:
**29.10.86 Bulletin 86/44**

(84) Designated Contracting States:
**DE FR GB IT NL SE**

(56) References cited:
**DE-B-1 623 871**
**GB-A-2 019 070**
**US-A-3 673 992**
**US-A-4 262 255**

**ELECTRONIQUE ET APPLICATIONS INDUSTRIELLES, no. 268, 1st May 1979, pages 19-21, Paris, FR. PH. SCHWARTZ: "Les échelles lumineuses: les avantages des indicateurs numériques et analogiques"**

(73) Proprietor: **REGIE NATIONALE DES USINES RENAULT**
**Boîte postale 103 8-10 avenue Emile Zola**
**F-92109 Boulogne-Billancourt (FR)**

(73) Proprietor: **STANLEY ELECTRIC CO., LTD.**
**Research & Development Laboratory 2456, Eda-Machi Midori-ku**
**Yokohama-shi Kanagawa-Ken 227 (JP)**

(72) Inventor: **Teshima, Thoru**
**4606-4, Motoishikawa-Cho Midori-Ku**
**Yokohama-Shi Kanagawa-Ken (JP)**
Inventor: **Funaoka, Chihiro**
**No. 202 Shinwa Corpo 44-7, Akabanenishi 4-Chome**
**Kita-Ku Tokyo (JP)**
Inventor: **Robert, Pierre-Henri**
**4, Résidence des 3 Forêts**
**F-78380 Bougival (FR)**

(74) Representative: **Colas, Jean-Pierre et al**
**Cabinet de Boisse 37, avenue Franklin Roosevelt**
**F-75008 Paris (FR)**

Courier Press, Leamington Spa, England.

## Description

The present invention relates to a display unit for a car tachometer.

It is already known from US—A—3,673,992, to provide in a car tachometer display unit, an engine revolution monitoring circuit receiving at its input ignition pulse signals of the engine and delivering at its output signals corresponding to the actual velocity of engine revolutions. This display unit also comprises a display device having a rotary pointer and a speed scale having the shape of an arc and cooperating with the free end of the pointer. The display device is controlled by a driving circuit and a critical revolution circuit has its input connected to the output of the operational circuit for enabling acting when a critical number of engine revolutions is reached. The critical number is determined by means of another pointer which can be adjusted by the driver, the arrangement being such that when the critical number is reached, engine cut-off means are actuated.

Thus, this known arrangement deals with the problem of stopping the engine when the actual velocity pointer coincides with the second adjustable pointer whereby an electrical contact is closed so as to initiate the engine stopping.

The present invention has as its major object to provide a display unit for a car tachometer giving clear information to the driver as to actual engine speed and to the critical number of engine revolutions reached during driving while leaving to the driver the decision of modifying the engine speed as required.

Thus, the car tachometer display unit according to the invention comprises an engine revolution velocity monitoring circuit receiving at its input ignition pulse signals of the engine and delivering at its output signals corresponding to the actual velocity of engine revolution, a display device, a driving circuit, whose output is connected with the input of the display device for driving the display device and a critical revolution velocity decision circuit, whose input is connected with the output of the monitoring circuit, said critical revolution velocity decision circuit being operative when a critical velocity of engine revolution is attained or exceeded, the display unit being characterized in that the display device is a liquid-crystal bar graphic display comprising a predetermined number of segments, in that the output of the critical revolution velocity decision circuit is connected with a first input of the driving circuit, in that the display unit further comprises a warning revolution velocity decision circuit, whose input is connected with the output of said mono-itorng circuit and whose output is connected with a second input of the driving circuit, said warning circuit being in a first state when the actual velocity of engine revolutions is smaller than a warning velocity of engine revolutions and in a second state when the actual velocity of engine revolutions exceeds the warning velocity, the warning velocity being smaller than the critical velocity, and a bar graph decoder, whose input is connected to the monitoring circuit and whose output is connected to a third input of the driving circuit, in that the display unit is so arranged that, when the warning circuit is in the first state, it selectively drives on one hand the segments displaying the warning velocity and on the other hand the segments from a first one corresponding to the minimum velocity of detectable revolutions, to a second one corresponding to the actual number of revolutions and, when the warning circuit is in the second state it selectively drives all the segments from the first one to the second one except the segment displaying the warning velocity and in that the display device operates in a flashing mode when the critical revolution decision circuit is operative.

According to these features, the driver of a car comprising this display unit may be aware at any moment of the engine velocity and of whether the velocity exceeds the warning number of revolutions and reaches the critical value or not. This information is clearly displayed by means of liquid-crystal segments having the shape of juxtaposed bars, the dangerous condition of exceeding the critical velocity being displayed by a flickering operation of the display.

From DE—B—1,623,871, it is further known to use a row of light-cells along a scale for displaying the actual magnitude of the value to be measured. The display can be made in several ways i.e. by brightening and/or darkening specific cells or by lightening of flickering all the other cells except the cell corresponding to the value to be displayed. However, this prior art document fails to teach the display of a warning value and a critical value in a manner emphasized in the present invention.

The article of the review "Electronique et Applications Industrielles", No 268, 1 May 1979, pages 19-21, Paris, "Les échelles, lumineuses: les advantages des indicateurs numériques et analogiques" (ph. Schuerte), discloses the use of light elements such as gaseous plasma tubes, fluorescent cells or light emitting diodes, such elements being arranged in a row along a measuring scale. Means are disclosed for making the row flickering when a threshold value is exceeded. This disclosure does not deal with the combined display of a warning value and a critical value by means of liquid-crystal bars in the manner emphasized in the present invention.

Finally, a cross-reference citation is hereby made of EP—A—0,092,486 and EP—A—0,092,485 both filed in the name of the Applicants of the present application and at the same date. These documents disclose display units of a speedometer for an automobile.

Referring now in detail to the accompanied drawings, description is made on the construction of one embodiment of this invention:

— Fig. 1 is a block diagram illustrating the whole of one embodiment of a display unit of a tachometer for an automobile according to this invention;

— 2 is a front view of a display device of the display unit according to this invention; and

— Fig. 3 (a) (b) (c) (d) are explanatory views showing several display states of the display device according to the invention, wherein for each segment of the display device, obliquely lined segments show a working state, while lineless segments show an inactive state.

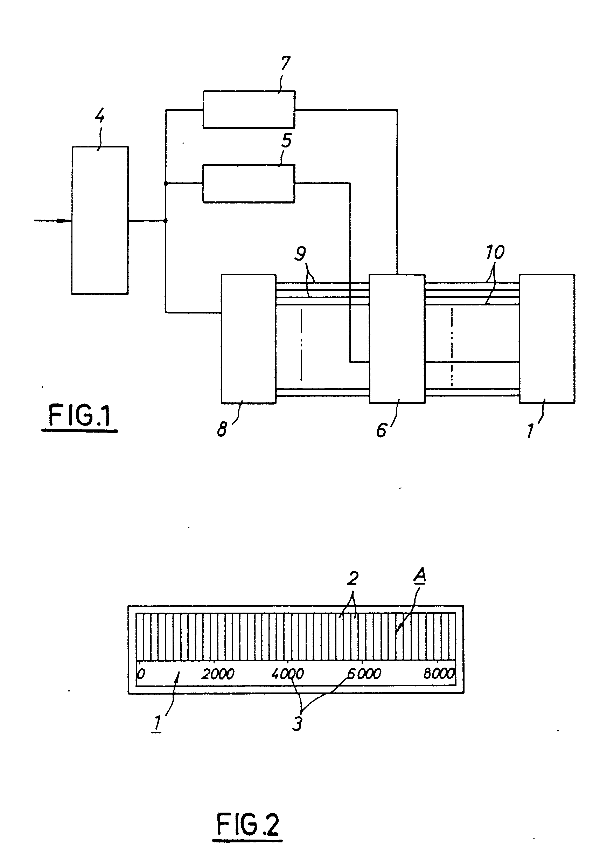

Referring now to the drawings, and in particular to Fig. 2, numeral 1 designates a display device which is formed as a bar graphic display A comprising a predetermined number of segments 2 using, for example, liquid crystal display technology. Namely, in the illustration, n-piece segments 2 each the same in size and formed of long and narrow plates are arranged and connected together, and each one piece of the segments is displayed in sequence as a basic unit of the total scale, for example units of 100 rpm, 200 rpm and so on. Numeral 3 designates scales shown on the necessary positions of the aforesaid display device 1. In case of necessity, color displays may be made, together with the scales 3, with yellow for warning revolution area, red for critical revolution area, and so on.

Accordingly, the display device 1 can display proper numerical values as a result of changes in condition of light and darkness, transparency and turbidity, etc. which are caused by the changes of optical properties of the liquid crystal relative to the necessary segment 2 on which voltage is impressed and are different from the liquid crystal relative to the necessary segment 2 on which voltage is impressed and are different from the liquid crystal relative to other segments on which no voltage is impressed. Also, the display device 1 may take the necessary construction easy for a driver to watch in the daytime and nighttime, with transmitted light, reflected light, etc... by display means under DS (dynamic scattering) system, TN (twisted nematic) system, ECB (electrically controlled birefringence) system, PC (phase change) system, etc. . . according to the difference in the mechanism transforming the changes in condition of liquid crystal caused by electric signals into optical information.

Further, as to the display device 1, each segment 2 can freely be arranged, for example an arrangement in an up-to-down direction, or an arrangement in the right-to-left direction as shown, and can be constructed to desired shapes without limiting the construction shown. Further, number of display devices 1 can be formed in a circular arc, circle, circular ring, etc. . . as desired according to the shapes of the segments.

Referring now to Fig. 1, numeral 4 designates an engine revolution monitoring circuit which is so arranged as to receive ignition pulse signals of an automobile engine and to produce at an output a signal indicative of the number of engine revolutions per minute (rpm), as desired.

Numeral 5 designates a warning revolution decision circuit, in which a warning number of revolutions is selectively set to 5,500 rpm, and which is connected to the operational circuit 4.

When the number of revolutions per minute is smaller in value than 5,500 rpm, then the segment 2 corresponding to 5,500 rpm of the display device 1, can be activated through driving circuit 6 of the display device 1, the warning revolution decision circuit 5 being capable of making the display device 1 perform liquid-crystal displaying by producing optical changes in the liquid crystal of the respective segment 2 by application of a drive signal from the driving circuit 6 through a respective connecting wire 10; when the number of engine revolutions per minute is greater than 5,500 rpm, the warning revolution decision circuit 5 enables the segment 2 corresponding to 5,500 rpm to be no longer driven by stopping the functioning of the driving circuit 6.

Numeral 7 designates a critical revolution decision circuit, in which a critical number of revolutions is selectively set to 6,000 rpm, and is connected to the engine revolution monitoring circuit 4. Further, when the number of engine revolutions per minute reaches a value exceeding 6,000 rpm, then the segment 2 corresponding to 6,000 rpm of the display device 1, is actuated through the driving circuit 6 of the display device 1, the critical revolution decision circuit 7 being capable of making the display device 1 perform flickering display of all the segments 2 corresponding to the number of revolutions per minute thereby responding to higher speed by delivering intermittently the display inhibiting signals to the driving circuit 6. Also, it may be so arranged as to allow easy change of the aforesaid warning number of revolutions and of the critical number of revolutions by means of setting.

Number 8 designates a bar graph decoder for making the driving circuit 6 of the display device 1 function, and is so arranged as to drive n-1 of the segments 2 by means of a respective connecting wire 9, with the exclusion of one of the segements 2, which is driven by signals transmitted by the aforesaid warning revolution decision circuit 5.

Accordingly, when output signals corresponding to N number of revolutions are transmitted by the engine revolution monitoring circuit 4 and are supplied to the bar graph decoder 8, all of the segments 2 except the segment 2 corresponding to N revolutions are driven and can show optical changes.

Based on the construction mentioned above, description is made on the operation of this invention.

With the starting of the automobile engine, the number of engine revolutions is supplied in the form of ignition pulse signals to the engine revolution monitoring circuit 4.

In the circuit 4, the number of engine revolutions is determined, and the output signals corresponding to the determined number of engine revolutions are transmitted to the bar graph decoder 8, the warning revolution decision circuit 5 and the critical revolution decision circuit 7 to control the operation of the driving circuit 6.

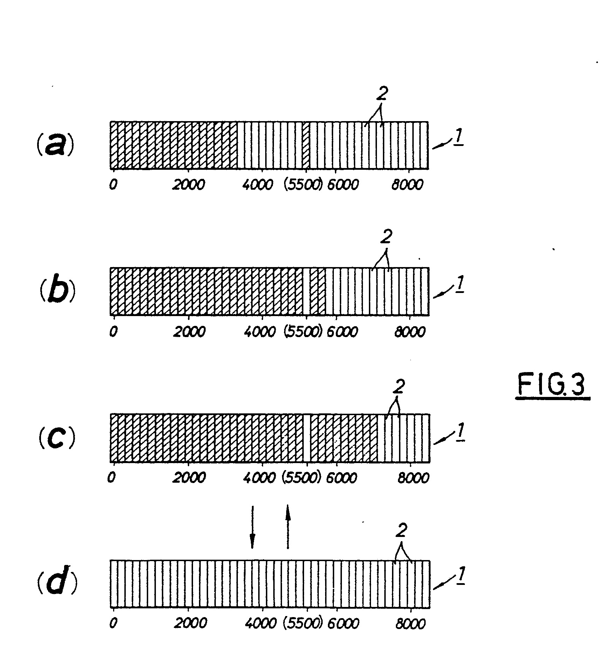

As the output signals corresponding to the actual number of revolutions of the engine, which

signals act on the whole necessary number of connecting wires 9, are transmitted by the bar graph decoder 8, if the number of revolutions of the engine is smaller in value than the aforesaid warning number of revolutions (5,500 rpm), the number of revolutions of the engine is displayed by activating corresponding display segments 2, as shown by the liquid-crystal display segment obliquely lined in Fig. 3(a).

In case the number of revolutions of the engine exceeds the aforesaid warning number of revolutions, e.g. 5,500 rpm, the bar graph decoder 8 is not connected with the segments corresponding to the warning number of revolutions, whereby the display segments are activated to come to the state shown in Fig. 3 (b).

The driving circuit 6, when the number of engine revolutions is smaller in value than 5,500 rpm, in conjunction with the circuit 5 performs the liquid-crystal display shown by oblique line portions of Fig. 3 (a) by driving only the segments 2 corresponding to the number of engine revolutions and the segment 2 corresponding to 5,500 rpm.

When the number of engine revolutions exceeds the warning number of revolutions (5,500 rpm), the output signals from the driving circuit 6 acting on the 5,500 rpm segment 2 are stopped, so that the 5,500 rpm segment 2 does not work, and the segments are displayed as shown in Fig. 3 (b).

When the numner of engine revolutions further increases to reach the critical number of revolutions, e.g. 6,000 rpm or more, intermittent control signals are transmitted by the critical revolution decision circuit 7 to the driving circuit 6, so that the segments 2 can display the critical state by flickering between operational states as shown in Fig. 3 (c) and 3 (d).

In case the number of engine revolutions equals the warning number of revolutions or is smaller in value by one unit amount, there is caused an inconvenience since the display cannot distinguish the actual number of revolutions of the engine from the warning number of revolutions. However, this does not interfere with the practical use if a driver recognizes the fact of reaching the warning revolution area by assuming the case mentioned above in advance.

Thus, description was made on one embodiment of this invention, which is not limited to the aforesaid embodiment but can be, of course, practiced with many alternations or modifications in the field of art to which this invention belongs.

This invention has an advantage of making a driver enjoy safe driving by preventing reckless driving because, as mentioned above, the display shows the number of revolutions of the engine on the bar graph display by using segments such as liquid-crystals. This invention makes it possible for a driver to constantly compare the number of revolutions of the engine with a warning number of revolutions by setting such number of revolutions and by displaying the segments corresponding to such warning number of revolutions, and has further advantage of being able to secure more safety because, as mentioned above, the bar graphic display of the display device flickers to make it possible to give a driver warning when the number of engine revolutions exceeds the critical number of revolutions.

Also, according to this invention, the display device, which is constructed by means of a bar graph display, exhibits good style and is easy for a driver to watch.

## Claim

A car tachometer display unit comprising:
— an engine revolution velocity monitoring circuit (4) receiving at its input ignition pulse signals of the engine and delivering at its output signals corresponding to the actual velocity of engine revolution,
— a display device (1),
— a driving circuit (6), whose output is connected with the input of the display device (1), for driving the display device, and,
— a critical revolution velocity decision circuit (7), whose input is connected with the output of the monitoring circuit (4), said critical revolution velocity decision circuit being operative when a critical velocity of engine revolution is attained or exceeded, characterised in that the display device (1) is a liquid-crystal bar graphic display comprising a predetermined number of segments (2), in that the output of the critical revolution velocity decision circuit (7) is connected with a first input of the driving circuit (6), in that the display unit further comprises a warning revolution velocity decision circuit (5), whose input is connected with the output of said monitoring circuit (4) and whose output is connected with a second input of the driving circuit (6), said warning circuit (5) being in a first state when the actual velocity of engine revolutions is smaller than a warning velocity of engine revolutions and in a second state when the actual velocity of engine revolutions exceeds the warning velocity, the warning velocity being smaller than the critical velocity, and a bar graph decoder (8), whose input is connected to the monitoring circuit (4), and whose output is connected to a third input of the driving circuit (6), in that the display unit is so arranged that, when the warning circuit (5) is in the first state, it selectively drives on one hand the segment displaying the warning velocity and on the other had the segments from a first one corresponding to the minimum velocity of detectable revolutions to a second one corresponding to the actual number of revolutions and, when the warning circuit (5) is in the second state it selectively drives all the segments from the first one to the second one except the segment displaying the warning velocity and in that the display device (1) operates in a flashing mode when the critical revolution decision circuit (7) is operative.

## Patentanspruch

Anzeigevorrichtung für Kraftfahrzeugdrehzahlmesser mit
— einem Motordrehzahlanzeige-Stromkreis (4), der an seinem Eingang Zündimpulssignale des Motors aufnimmt und an seinem Ausgang Signale abgibt, die der momentanen Drehzahl des Motors entsprechen,
— einer Anzeigeeinheit (1),
— einem Betriebs-Stromkreis (6) für den Betrieb der Anzeigeeinheit, dessen Ausgang mit dem Eingang der Anzeigeeinheit (1) verbunden ist,
— und einem Unterscheidungs-Stromkreis (7) für die kritische Drehzahl, dessen Eingang mit dem Eingang des Motordrehzahlanzeige-Stromkreises (4) verbunden ist, welcher Unterscheidungs-Stromkreis wirksam ist, wenn eine kritische Motordrehzahl erreicht oder überschritten ist, dadurch gekennzeichnet, daß die Anzeigeeinheit (1) ein Flüssigkristall-Balkenanzeiger ist, der eine vorgegebene Zahl von Segmenten (2) aufweist, daß der Ausgang des Unterscheidungs-Stromkreises (7) mit einem ersten Eingang des Betriebs-Stromkreises (6) verbunden ist, daß die Anzeigevorrichtung außerdem einen Warnunterscheidungs-Stromkreis (5) für die kritische Drehzahl aufweist, dessen Eingang mit dem Ausgang des genannten Motordrehzahlanzeige-Stromkreises (4) verbunden ist und dessen Ausgang mit einem zweiten Eingang des Betriebs-Stromkreises (6) verbunden ist, wobei der genannte Warnunterscheidungs-Stromkreis (5) sich in einem ersten Zustand befindet, wenn die momentanen Motordrehzahlen kleiner sind als eine Warn-Motordrehzahl und in einem zweiten Zustand, wenn die momentanen Motordrehzahlen größer sind als die Warn-Motordrehzahl, wobei die Warn-Motordrehzahl kleiner ist als die kritische Motordrehzahl, daß ein Balkenanzeiger-Dekodierer (8) vorgesehen ist, dessen Eingang mit dem Motordrehzahl-Anzeige-Stromkreis (4) und dessen Ausgang mit einem dritten Eingang des Betriebsstromkreises (6) verbunden ist, daß die Anzeigeeinheit so angeschaltet ist, daß dann, wenn der Warnunterscheidungs-Stromkreis (5) in seinem ersten Zustand ist, er selektiv einerseits dasjenige Segment aktiviert, daß die Warn-Motordrehzahl darstellt und andererseits diejenigen Segmente, die bei einem ersten Segment beginnen, das der Minimum-Motordrehzahl von meßbaren Motordrehzahlen entspricht und bei einem zweiten Segment enden, das der momentanen Motordrehzahl entspricht und daß dann, wenn der Warnunterscheidungs-Stromkreis (5) in seinem zweiten Zustand ist, er selektiv alle Segmente vom ersten Segment bis zum zweiten Segment hin aktiviert mit Ausnahme des die Warn-Motordrehzahl anzeigenden Segmentes, und daß die Anzeigeeinheit (1) in einem blinkenden Modus arbeitet, wenn der Unterscheidungsstromkreis (7) wirksam ist.

## Revendication

Dispositif d'affichage pour un tachymètre pour véhicule comprenant:
— un circuit (4) de surveillance de la vitesse de rotation du moteur recevant sur son entrée des signaux d'impulsions d'allumage du moteur et délivrant sur sa sortie des signaux correspondant à la vitesse réelle de rotation du moteur,
— un indicateur (1),
— un circuit de commande (6) dont la sortie est connectée à l'entrée de l'indicateur (1) pour le commander, et,
— un circuit (7) de décision de vitesse de rotation critique dont l'entrée est connectée à la sortie du circuit de surveillance (4), ledit circuit de décision de vitesse critique étant actif lorsqu'une vitesse de rotation critique est atteinte ou dépassée, caractérisé en ce que l'indicateur (1) est un affichage graphique à barres de cristaux liquides comprenant un nombre prédéterminé de segments (2), en ce que la sortie du circuit (7) de décision de vitesse de rotation critique est connectée à une première entrée du circuit de commande (6); en ce que le dispositif d'affichage comprend en outre un circuit (5) de décision de vitesse de rotation d'avertissement, dont l'entrée est connectée à la sortie du circuit de surveillance (4) et dont la sortie est connectée à une seconde entrée du circuit de commande (6), ledit circuit d'avertissement (5) étant dans un premier état, lorsque la vitesse de rotation réelle du moteur est inférieure à une vitesse de rotation d'avertissement du moteur, et dans un second état, lorsque la vitesse réelle de rotation du moteur dépasse la vitesse d'avertissement, la vitesse d'avertissement étant inférieure à la vitesse critique, et un décodeur (8) de graphe à barres dont l'entrée est connectée au circuit de surveillance (4) et dont la sortie est connectée à une troisième entrée du circuit de commande (6), en ce que le dispositif d'affichage est agencé de telle façon que, lorsque le circuit d'avertissement (5) se trouve dans son premier état, il commande sélectivement, d'une part, les segments affichant la vitesse d'avertissement, et d'autre part, les segments allant d'un premier segment correspondant à une vitesse minimale de rotation détectable à un second segment correspondant au nombre réel de tours et que, lorque le circuit d'avertissment (5) se trouve dans son second état, il commande sélectivement tous les segments du premier au second segment, à l'exception de celui affichant la vitesse d'avertissement, et en ce que l'indicateur (1) fonctionne dans un mode de clignotement lorsque le circuit (7) de décision de rotation critique est actif.

FIG.1

FIG.2

(a)

(b)

**FIG.3**

(c)

(d)